# EUROPEAN PATENT APPLICATION

(11) **EP 3 401 648 A1**
(43) Date of publication of application: **14.11.2018**
(21) Application number: 17461531.0
(22) Date of filing: 09.05.2017
(51) Int. Cl.: G01F 1/06, G01F 1/10, G01F 3/06, H03B 5/08

(54) **A MECHANICAL DRUM-TYPE COUNTER FOR A CONSUMPTION METER**

(71) Applicant: Aiut Sp. z o.o., 44-109 Gliwice (PL)
(72) Inventor: Gabrys, Marek, 44-100 Gliwice (PL)
(74) Representative: AOMB Polska Sp. z.o.o.

(57) **Abstract**

The invention relates to a mechanical drum-type counter (7) for a consumption meter (8), comprising: at least one rotating wheel (2), the rotation of which corresponds to a measured flow of a fluid, and a target element (1) fixed to the wheel (2), preferably the index drum. The target element (1) is a conductive non-magnetic target element, preferably made of nonferrous metal, and is fixed at least partially within the circumference of the wheel (2). The invention also relates to a consumption meter (8) comprising the counter (7) according to the invention and a sensor (3) suitable for and configured to detect the target element (1). Moreover, the invention relates to a method of adaptation an existing mechanical drum-type counter for a consumption meter, involving the replacement of a magnetic target element with a conductive non-magnetic target element (1).

## Description

### Technical field

The invention relates to a mechanical drum-type counter for a consumption meter, the consumption meter comprising said counter and a method of improving an existing mechanical drum-type counter.

### Background

Flow meters with a mechanical drum-type counter comprising a magnet on at least one of wheels (usually the least significant wheel, i.e. the index drum) and a sensor (usually reed switch or Hall effect sensor) suitable for detecting the magnet position, have been known for a long time and well-tested. In such type of flow meters the sensor enables to calculate the flow by counting how many times the magnet passed the sensor. This further allows to use the automated meter reading (AMR) technology. However, due to the presence of the magnet the meter readings can be manipulated, for example by placing a strong magnet in a proximity of the meter.

US 20050140364 A1 discloses a device for sensing the rotation of a rotary member, e.g. in a water meter turbine. The sensor consists of two coils connected to oscillators, each of them being close with one of its end to the rotary member. The rotary member is a disc made of non-metallic material bearing a metallic mark on part of its surface. Movement of the mark relative to the sensor affects the oscillation amplitude. The changes of this amplitude are recorded and used to determine the rotational speed of the rotary member.

Further, US2013035889 discloses a method for detecting a rotation and direction of rotation of a rotor, on which at least one damping element is positioned. Two sensors arranged in close proximity of the rotor are damped depending on a position of the damping element. This principle is used to determine not only the fact of rotation of the rotor, but also the direction of this rotation (forward or backward).

Yet further, US9255818B2 discloses a method for precise measurement of rotation of a device by means of several coils arranged next to each other and in proximity of a metallic element causing voltage changes induces in the coils.

There is, however, a continuous need for further improvements in case of counters allowing to use AMR technology, which would also show reduced sensitivity to magnetic field generated by externally applied magnets and which also would require minimum modification of mechanical components.

### Summary of the invention

The main aim of the present invention was to provide a meter which would be less sensitive for manipulation by externally applied magnets, with as little modification of the construction of known meters as possible.

The solution is to provide a meter, wherein a magnet (fixed to at least one rotating wheel of the counter, preferably the index drum defining the least significant digit in the flow record) is replaced by a conductive target element, which can be detected by a proximity sensor placed in a distance allowing for detection. The meter comprising the conductive target element, optionally made of nonferrous metal, placed on one of the wheels of the meter (in particular a counter), and a proximity sensor suitable for detecting said target element is less sensitive for manipulation by externally applied magnetic fields than the meters comprising a magnet.

As mentioned above, flow meters with a mechanical drum-type counter comprising a magnet on at least one of the wheels have been known for a long time and well-tested.

Therefore it would be advantageous to provide the meter being less sensitive to manipulation by externally applied magnets, but without involving significant adaptation of the index drum (or any other part of existing plastic mould of known magnet meters) or changes in production process, which is a specific object of the present invention.

The invention relates to a mechanical drum-type counter for a consumption meter, comprising:
at least one rotating wheel, the rotation of which corresponds to a measured flow of a fluid, and
a target element fixed to the wheel, preferably the index drum, wherein the target element is a conductive non-magnetic target element, preferably made of nonferrous metal or other conductive element, and is fixed at least partially within the circumference of the wheel.

Preferably, the target element is in form of a solid metal block (cuboid, barrel), a thin metal plate, a coil or an RLC circuit.

Preferably, the target element is placed in a receiving socket formed in the wheel. In a particularly preferred embodiment, the target element is in form of a cuboid, preferably made of non- magnetic metal or a resonance circuit (also a conductive element) in resin epoxide, said cuboid being fitted into the receiving socket.

Preferably, the wheel comprising the target element further comprises a counterweight (non-magnetic).

The invention also relates to a consumption meter, in particular a gas meter, comprising the counter defined above and a sensor suitable for and configured to detect the target element. Preferably, the sensor is an inductive proximity sensor, which is designed to operate by generating an electromagnetic field and detecting the eddy current losses generated when non-magnetic metal target elements enter the field.

An induction sensor utilizing eddy currents is based on a coil with or without a core, in which an electric current is forced to oscillate. Electric current flowing through the coil generates a variable electromagnetic field in the surrounding space, inducing eddy currents in other conductors present in this space. The other conductors generate in turn their own variable electromagnetic fields, inducing eddy currents back in the initial coil. Reverse currents induced in the coil increase the attenuation of the oscillations in the coil.

In sensors, wherein the coil is a component of the oscillator, the increased attenuation reduces the oscillation amplitude even to zero. In sensors using eigen-oscillations of the LC circuit the increased attenuation shortens the oscillation time.

For both types of sensors mentioned above, the signal coming from the coil, generally voltage, is further analyzed by a decision system indicating the presence of generated eddy currents and electromagnetic field in the conductive element.

For example, in the present invention the proximity sensor as disclosed in EP 3107207 A1 may be used.

Moreover, the invention relates to a method of adaptation an existing mechanical drum-type counter for a consumption meter, wherein said counter comprises at least one rotating wheel, the rotation of which corresponds to a measured flow of a fluid, and a magnetic target element fixed at least partially within the circumference of the wheel, said method comprising a step of replacing a magnetic target element with a conductive non-magnetic target element.

The effect of the present invention is that the existing production process and tools, body, plastic mould, metrological characteristics of known magnet meters can be used as a basis for the new, magnet-proof meters. The meter according to the invention may be obtained by placing a conductive target element within the wheel, in the place designed for receiving a magnet (usually such place is formed as a socket). As a result, the magnet-proof meter may be easily produced. The production process, as well as all the certificates obtained for the existing mechanical parts of the meter are not affected by the simple change of the target element.

### Brief description of drawings

Now, the invention will be presented in greater detail in a preferred embodiment, with reference to the accompanying drawings, in which:
Fig. 1 is a cross-section of the counter according to the invention.
Fig. 2 is a perspective view of the counter according to the invention;
Fig. 3 illustrates the operation of the counter according to the invention;
Fig. 4 is a schematic view of the consumption meter according to the invention;

### Detailed description of the preferred embodiment

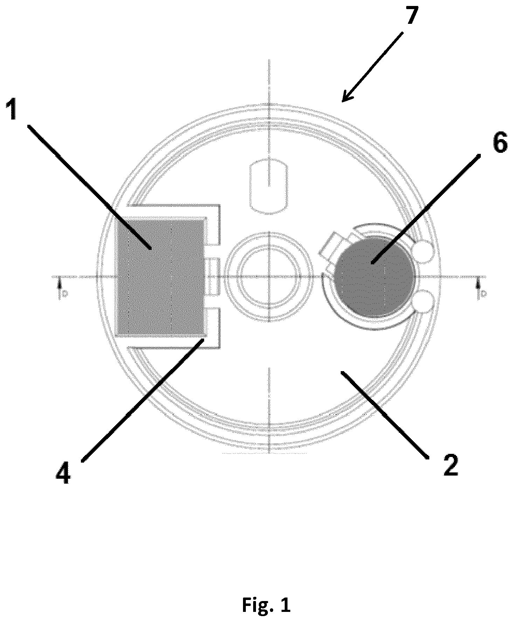

Fig. 1 shows the counter 7 according to the preferred embodiment of the invention. The counter 7 comprises at least one wheel 2, wherein a receiving socket 4 is formed. A non-magnetic target element 1 in form of an epoxide cuboid comprising conducing element is fitted into the receiving socket 4. On the opposite side of the wheel 2 a counterweight 6 is fixed.

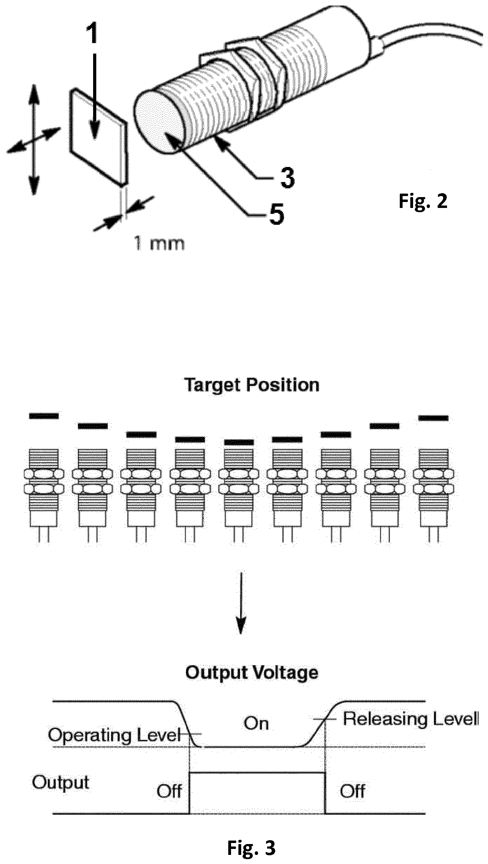

In fig. 2 the counter 7 according to the preferred embodiment is shown in a perspective view, wherein a sensor 3 with its active surface 5 is facing the target element 1. In this exemplary embodiment the sensor consists of a coil on a ferrite core, an oscillator, a trigger-signal level detector and an output circuit. The active surface 5 of the sensor 3 in form of an inductive proximity switch is a surface wherein a high-frequency electro-magnetic field emerges.

An exemplary standard target element 1 is a mild steel square, 1 mm thick, with side lengths equal to the diameter of the active surface 5 or three times the nominal switching distance, whichever is greater (fig. 2). For example, the target element 1 may be detected by a proximity sensor 3 having its active surface 5 positioned at most 4 mm from the target element 1.

In another preferred embodiment (fig. 1) the target element 1 is not in form of a plate, but of a cuboid formed of nonferrous metal. This cuboid is fitted into the receiving socket 5 of the wheel 2. In such case the plate thickness does not affect the effectiveness of the operation of the target element 1. Operating range of the inductive sensor 3 in combination with such cuboid target is sufficient for reliable operation. In an alternative embodiment the cuboid can be also formed of a resin (such as epoxy resin) containing a resonant element such as a copper coil.

Fig. 3 shows the sequence of phases during the operation of the counter 7. As the target element 1 approaches the sensor 3 and advances into the electromagnetic field generated by the coil of the sensor 3, eddy currents are induced in the target element 1. Some energy generated by the oscillator is absorbed by the target element 1, resulting in loss of energy and a smaller amplitude of oscillation. Once the operating level is achieved, the detector circuit of the sensor 3 recognizes the corresponding specific change in amplitude of oscillation and generates a signal triggering the solid state output from "Off" to "On" status. In other terms, when the target element 1 is in sufficiently close range with respect to the sensor 3, the energy drain stops the oscillator and changes the output state. As the relative movement of the target element 1 and the sensor 3 continues, the distance between these elements goes through the minimum and starts to become greater again. Once the releasing level is achieved, the oscillator is no more damped and as a result a signal is generated triggering the solid state output from "On" to "Off" again.

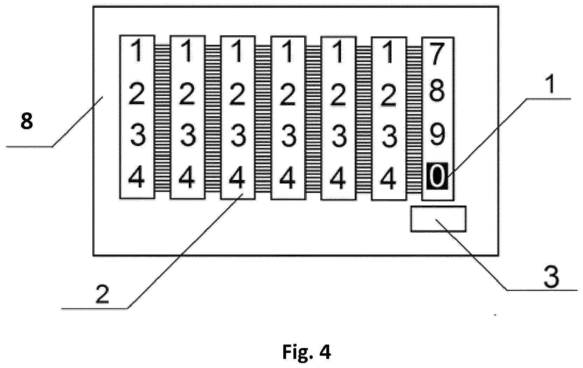

Fig. 4 shows a schematic view of an exemplary consumption meter 8 comprising the proximity sensor 3 and a conductive target element 1, fixed to one of the wheels 2, namely the last wheel corresponding to the least important digit.

## Claims

1. A mechanical drum-type counter (7) for a consumption meter (8), comprising:
at least one rotating wheel (2), the rotation of which corresponds to a measured flow of a fluid, and
a target element (1) fixed to the wheel (2), preferably the index drum,
**characterized in that** the target element (1) is a conductive non-magnetic target element, preferably made of nonferrous metal or other conductive element, and is fixed at least partially within the circumference of the wheel (2).

2. The counter (7) according to claim 1, **characterized in that** the target element (1) is in form of a solid metal block, a thin metal plate, a coil or an RLC circuit.

3. The counter (7) according to claim 1 or 2, **characterized in that** the target element (1) is placed in a receiving socket (4) formed in the wheel (2).

4. The counter (7) according to claim 3, **characterized in that** the target element (1) is in form of a cuboid, and comprising a conductive element, said cuboid being fitted into the receiving socket (4).

5. The counter (7) according to any of the preceding claims, **characterized in that** the wheel (2) comprising the target element (1) further comprises a counterweight (6).

6. A consumption meter (8), in particular a gas meter, comprising:
the counter (7) according to any of the preceding claims, and
a sensor (3) suitable for and configured to detect the target element (1).

7. The consumption meter (8) according to claim 6, **characterized in that** the sensor (3) is an inductive proximity sensor.

8. A method of adaptation an existing mechanical drum-type counter for a consumption meter, wherein said counter comprises at least one rotating wheel (2), the rotation of which corresponds to a measured flow of a fluid, and a magnetic target element fixed at least partially within the circumference of the wheel (2), said method comprising a step of replacing a magnetic target element with a conductive non-magnetic target element (1).
